# EUROPÄISCHE PATENTSCHRIFT

(11) **EP 3 322 560 B1**
(45) Veröffentlichungstag und Bekanntmachung des Hinweises auf die Patenterteilung: **08.01.2020**
(21) Anmeldenummer: 15739230.9
(22) Anmeldetag: 13.07.2015
(51) Int. Cl.: B25B 11/00, H01L 21/683

(54) **VAKUUM-GREIFVORRICHTUNG UND VERFAHREN ZUM BETREIBEN EINER VAKUUM-GREIFVORRICHTUNG**
VACUUM GRIPPING DEVICE AND METHOD FOR OPERATING A VACUUM GRIPPING DEVICE
DISPOSITIF DE PRÉHENSION VIDE ET PROCÉDÉ POUR FAIRE FONCTIONNER UN DISPOSITIF DE PRÉHENSION VIDE

(43) Veröffentlichungstag der Anmeldung: 23.05.2018
(73) Patentinhaber: Festo AG & Co. KG, 73734 Esslingen (DE)
(72) Erfinder: MAYER, Manuel, 78166 Donaueschingen (DE); ANDERLE, Jens, 73326 Deggingen (DE); WIRTL, Hannes, 86956 Schongau (DE)
(74) Vertreter: Patentanwälte Magenbauer & Kollegen Partnerschaft mbB
(86) Internationale Anmeldenummer: PCT/EP2015/065975
(87) Internationale Veröffentlichungsnummer: WO 2017/008837

(56) Entgegenhaltungen:
- WO-A1-2013/034635
- WO-A1-2013/120802
- DE-A1-102006 027 303
- DE-A1-102007 031 760
- DE-A1-102014 218 295

## Beschreibung

Die Erfindung betrifft ein Verfahren zum Betreiben einer Vakuum-Greifvorrichtung, die eine mindestens einen Sauggreifer aufweisende Sauggreifereinheit enthält, die über eine an sie angeschlossene Steuerventileinrichtung wahlweise mit einer in dem Sauggreifer einen Unterdruck hervorrufenden Vakuumquelle oder mit einer in dem Sauggreifer einen Abwurfimpuls erzeugenden Überdruckquelle verbindbar ist.

Die Erfindung betrifft ferner eine Vakuum-Greifvorrichtung, die insbesondere in dem vorgenannten Sinne betreibbar ist und die eine mindestens einen Sauggreifer aufweisende Sauggreifereinheit enthält, die über eine an sie angeschlossene Steuerventileinrichtung wahlweise mit einer in dem Sauggreifer einen Unterdruck hervorrufenden Vakuumquelle oder mit einer in dem Sauggreifer einen Abwurfimpuls erzeugenden Überdruckquelle verbindbar ist, wobei zur Ansteuerung der Steuerventileinrichtung eine elektronische Steuereinheit vorhanden ist und wobei der Sauggreifereinheit mindestens eine zur Messung des in ihr herrschenden Ist-Druckes geeignete und mit der elektronischen Steuereinheit kommunizierende Druckmesseinrichtung zugeordnet ist.

Aus der DE 10 2007 031 760 A1 ist eine in dem vorgenannten Sinne aufgebaute und betreibbare Vakuum-Greifvorrichtung bekannt, die es ermöglicht, umzupositionierende Gegenstände vorübergehend mittels Unterdruck zu greifen und zu halten und den ergriffenen Gegenstand nach Verbringen an einen gewünschten Ablageort mittels eines als Abwurfimpuls bezeichneten Überdruckimpulses von dem ihn festhaltenden Sauggreifer abzuwerfen. Eine elektrisch ansteuerbare Steuerventileinrichtung ist dabei in der Lage, eine den Sauggreifer und eine die Verbindung zu dem Sauggreifer herstellende Arbeitsleitung enthaltende Sauggreifereinheit wahlweise mit einer Vakuumquelle oder einer Überdruckquelle zu verbinden. Zur Ansteuerung ist die Vakuum-Greifvorrichtung mit einer elektronischen Steuereinheit ausgestattet, die auch in der Lage ist, einen in der Sauggreifereinheit gemessenen Ist-Druck auszuwerten, um beispielsweise ständig die Einhaltung eines gewünschten Unterdruckniveaus zu überwachen, während der ergriffene Gegenstand umpositioniert wird. Die Erzeugung des Abwurfimpulses erfolgt dadurch, dass die Sauggreifereinheit mittels der Steuerventileinrichtung mit variabel einstellbarer Strömungsrate mit der Überdruckquelle verbunden wird, sodass die Zeit, innerhalb der das Vakuum im Sauggreifer abgebaut und eine mehr oder weniger hohe Abwurfkraft aufgebaut wird, variiert werden kann. Allerdings zeigen die hierbei notwendigen Einstellparameter eine recht starke Abhängigkeit von den jeweiligen Systemrandbedingungen wie beispielsweise der Höhe des von der Überdruckquelle zur Verfügung gestellten Nennüberdruckes oder der Länge einer zwischen der Steuerventileinrichtung und dem Sauggreifer verlaufenden Arbeitsleitung der Sauggreifereinheit. Folglich ist für jede Greifvorrichtung eine individuelle Anpassung vor der Inbetriebnahme erforderlich. Dabei ist das Auffinden der optimalen Einstellung stets sehr zeitaufwendig, zumal auch die Größe und das Gewicht der zu ergreifenden Gegenstände eine maßgebliche Rolle spielen.

Ist beispielsweise die eingestellte Impulsdauer des Abwurfimpulses zu kurz und der daraus resultierende Luftdurchsatz entsprechend gering, wird das Vakuum im Sauggreifer nicht vollständig aufgehoben und der Gegenstand bleibt am Sauggreifer haften. Ist die Impulsdauer hingegen zu lang und der Luftdurchsatz zu groß, kann der Abblasvorgang dazu führen, dass der abgeworfene Gegenstand oder auch umliegende Gegenstände aus der zugeordneten Ablagevorrichtung herausgeblasen werden und keine reproduzierbare Ablage der Gegenstände durchführbar ist.

Einer vergleichbaren Problematik unterliegt auch die in der DE 10 2008 005 241 A1 beschriebene Vakuum-Greifvorrichtung, bei der der Abwurfimpuls rein zeitgesteuert während einer empirisch ermittelten, fest oder einstellbar vorgegebenen Zeitdauer generiert wird.

Die WO 2013/120802 A1 betrifft ein Verfahren zum Betreiben eines Handhabungssystems mit einer Unterdruckhandhabungsvorrichtung zur Handhabung eines Werkstücks und einen Unterdruckerzeuger zum Erzeugen von Unterdruck. Eine Steuer- und/oder Regeleinrichtung ist dazu ausgebildet, ein Saugventil und/oder ein Abblasventil in Abhängigkeit eines in einem Diagnosezyklus ermittelten Gleichgewichtdrucks und/oder der mit dem Saugdrucksensor und/oder dem Versorgungsdrucksensor und/oder gegebenenfalls mit einer Zeitmesseinrichtung gemessenen Werte anzusteuern.

Die DE 10 2007 031760 A1 beschreibt ein als Proportionalventil ausgebildetes Abwurfventil.

Die DE 10 2014 218295 A1 beschreibt ein Verfahren, bei dem ein bestehender Unterdruck an einem Sauger durch eine Sensoreinrichtung oder einen Sensor überwacht wird.

Die DE 10 2006 027303 A1 nennt Vakuumerzeugervorrichtungen, die üblicherweise über Schlauchleitungen mit Sauggreifern verbunden werden.

Der Erfindung liegt die Aufgabe zugrunde, Maßnahmen zu treffen, die eine von den jeweiligen Systemrandbedingungen zumindest im Wesentlichen unabhängige Generierung eines auf den jeweiligen Greifgegenstand abgestimmten Abwurfimpulses ermöglichen.

Die Aufgabe wird durch ein Verfahren gemäß Anspruch 1 gelöst.

Gemäß dem erfindungsgemäßen Verfahren wird während der Erzeugung des Abwurfimpulses ein in der Sauggreifereinheit herrschender Ist-Druck gemessen und die Überdruckquelle mittels der Steuerventileinrichtung von der Arbeitsleitung abgetrennt, sobald bei der Messung des Ist-Druckes ein Druckabfall detektiert wird.

Messungen haben ergeben, dass im Druckverlauf des Ist-Druckes während der üblichen Erzeugung des Abwurfimpulses ein kurzer, aber deutlicher Druckabfall auftritt, der mit dem Ablösen des zuvor gegriffenen Gegenstandes vom Sauggreifer zusammenhängt. Das bevorzugte Verfahren wertet den Verlauf des Ist-Druckes aus und beendet die Überdruckbeaufschlagung der Sauggreifereinheit, wenn bei der Messung des Ist-Druckes der für den Abwurfvorgang charakteristische Druckabfall detektiert wird.

Die Aufgabe wird ferner durch eine Vakuum-Greifvorrichtung gemäß Anspruch 13 gelöst.

Im Vergleich zu bisher üblichen zeitgeführten oder auf den Luftdurchsatz abhebenden Verfahren und Vorrichtungen wird der sich bei Erzeugung des Abwurfimpulses in der mit der Überdruckquelle verbundenen Sauggreifereinheit einstellende Ist-Druck ausgewertet, sodass das System eine unverzügliche dahingehende Rückmeldung erhält, was sich sauggreiferseitig während des Aufbaus des Abwurfimpulses ereignet. Anhand des sich verändernden Ist-Druckes kann folglich direkt auf die Qualität des Gegenstandsabwurfvorganges geschlossen werden. Verfahren und Vorrichtung arbeiten in weiten Grenzen adaptiv und sind in der Lage, sich an veränderte Randbedingungen anzupassen. Der Einstellaufwand wird dadurch auf ein Minimum reduziert. Vor allem wenn es darum geht, sehr kleine und leichte Gegenstände wie beispielsweise Computerchips zu greifen und abzulegen, lässt sich mit den erfindungsgemäßen Maßnahmen gewährleisten, dass eine individuell angepasste Impulsdauer für ein sicheres und dennoch schonendes Abwerfen am Ablageort sorgt.

Vorteilhafte Weiterbildungen der Erfindung gehen aus den Unteransprüchen hervor.

Bei einer bevorzugten Ausgestaltung des Verfahrens erfolgt die Formung des Abwurfimpulses durch Überwachung einer Druckschwelle. Während der Erzeugung des Abwurfimpulses wird ein in der Sauggreifereinheit herrschender Ist-Druck gemessen, wobei die Überdruckquelle mittels der Steuerventileinrichtung von der Sauggreifereinheit abgetrennt wird, wenn der gemessene Ist-Druck einen vorgegebenen Überdruck-Grenzwert erreicht hat. Der Überdruck-Grenzwert ist vorzugsweise variabel vorgebbar. Zweckmäßigerweise wird ein Überdruck-Grenzwert gewählt, der bei 0,05 bar bis 0,15 bar liegt und der sich insbesondere im Bereich von 0,1 bar bewegt. Vorzugsweise wird eine Steuerventileinrichtung mit sehr kurzen Schaltzeiten eingesetzt, beispielsweise eine Piezoventileinrichtung, sodass besonders einfach ein nahezu überschwingfreier Druckverlauf des Ist-Druckes erreicht werden kann.

Eine weitere vorteilhafte Realisierung des Verfahrens sieht vor, dass während der Erzeugung des Abwurfimpulses wiederum ein in der Sauggreifereinheit herrschender Ist-Druck gemessen wird, wobei dieser Ist-Druck unter zumindest kurzzeitiger Überschreitung des Atmosphärendruckes durch entsprechende Ansteuerung der Steuerventileinrichtung auf einen Soll-Druck geregelt wird. Zur Durchführung dieses Verfahrens kommt als Steuerventileinrichtung zweckmäßigerweise eine Proportionalventileinrichtung zum Einsatz, die mit Hilfe eines entsprechenden Reglers, insbesondere eines PID-Reglers, eine gezielte Ausregelung des sauggreiferseitig herrschenden Ist-Druckes ermöglicht. Der Regler wird insbesondere so parametriert, dass im Druckverlauf des Ist-Druckes ein gezieltes und kontrolliertes Überschwingen in den Überdruckbereich provoziert wird, sodass sichergestellt ist, dass das Vakuum im Sauggreifer sicher abgebaut wurde und sich ein zuvor gegriffener Gegenstand vom Sauggreifer gelöst hat. Vorzugsweise wird der Ist-Druck bei der vorgenannten Druckregelung auf den atmosphärischen Druck ausgeregelt.

Die Detektion des Druckabfalls kann sehr präzise durch Ermittlung der beim Druckanstieg erstmalig auftretenden negativen Steigung folgen, und zwar mit Hilfe einer Differenzierung des Drucksignals in einer dafür ausgelegten elektronischen Steuereinheit.

Das auf der Detektion des Druckabfalls basierende Verfahren bietet auch die vorteilhafte Möglichkeit, die Detektion des Druckabfalls zur Erzeugung eines Abwurfbestätigungssignals heranzuziehen. Dieses Signal, das das erfolgte Abwerfen des Gegenstandes bestätigt, lässt sich in einer elektronischen Steuereinheit vorteilhaft für Folgeabläufe zugrundelegen.

Die Sauggreifereinheit verfügt zweckmäßigerweise über eine mit dem mindestens einen Sauggreifer verbundene Arbeitsleitung, die die Verbindung zwischen dem Sauggreifer und der Steuerventileinrichtung herstellt. Diese Arbeitsleitung kann ein in einem starren Körper ausgebildeter Kanal sein oder ist vorzugsweise von einer flexiblen Schlauchleitung gebildet, die sich einfach nach Bedarf verlegen lässt.

Der Ist-Druck wird vorzugsweise im Bereich des Sauggreifers gemessen, wobei sich insbesondere der Übergangsbereich zwischen der Arbeitsleitung und dem Sauggreifer anbietet. Hier lässt sich sehr einfach eine geeignete Druckmesseinrichtung, beispielsweise ein Drucksensor, einschalten.

Eine alternative Möglichkeit sieht eine Druckmessung des Ist-Druckes im Übergangsbereich zwischen der Steuerventileinrichtung und der Arbeitsleitung vor. Wegen der größeren Entfernung der Druckmesszone zum Sauggreifer ist hierbei eine gewisse Trägheit des Systems zu berücksichtigen.

Es besteht auch die vorteilhafte Möglichkeit, den Ist-Druck gleichzeitig an mehreren zueinander beabstandeten Stellen der Sauggreifereinheit zu messen und die gemessenen Ist-Druckwerte als Mittelwerte oder in sinnvoller Weise gewichtet zu verarbeiten.

Für das druckgeregelte Betriebsverfahren empfiehlt sich die Verwendung einer Proportionalventileinrichtung als Steuerventileinrichtung, vorzugsweise in einer Ausführung als Piezoventileinrichtung. Grundsätzlich kann eine Proportionalventileinrichtung aber auch für die anderen Realisierungsformen des erfindungsgemäßen Verfahrens genutzt werden. Alternativ zu der Proportionalventileinrichtung kann die Schaltventileinrichtung digital schaltbar ausgeführt sein und insbesondere über zwei Steuerventile verfügen, von denen das eine für die Verbindung der Sauggreifereinheit mit der Überdruckquelle und das andere für die Steuerung der Verbindung der Sauggreifereinheit mit der Vakuumquelle zuständig ist. Diese Steuerventile sind insbesondere als 2/2-Wege-Schaltventile ausgeführt. Für eine Quasi-Regelung können die als Schaltventile ausgeführten Steuerventile auch pulsweitenmoduliert eingesetzt werden.

Nachfolgend wird die Erfindung anhand der beiliegenden Zeichnung näher erläutert. In dieser zeigen:
- Figur 1: das Schaltbild einer bevorzugten Ausführungsform der erfindungsgemäßen Vakuum-Greifvorrichtung, deren Steuerventileinrichtung von einer Proportionalventileinrichtung gebildet ist,
- Figur 2: das Schaltbild einer alternativen Ausführungsform der erfindungsgemäßen Vakuum-Greifvorrichtung, deren Steuerventileinrichtung aus zwei digital schaltbaren Steuerventilen besteht,
- Figur 3: ein Diagramm, aus dem der grundlegende Druckverlauf des Ist-Druckes der Sauggreifereinheit beim Aufnehmen und Abwerfen eines Gegenstandes ersichtlich ist,
- Figur 4: das Diagramm einer bevorzugten ersten Ausführungsform des erfindungsgemäßen Verfahrens, dem das Prinzip einer Druckschwellenerkennung zugrunde liegt,
- Figur 5: das Diagramm einer weiteren Ausführungsform des erfindungsgemäßen Verfahrens, dem das Prinzip einer Druckregelung des Ist-Druckes zugrunde liegt, und
- Figur 6: das Diagramm eines weiteren vorteilhaften Ausführungsbeispiels des erfindungsgemäßen Verfahrens, dem das Prinzip der Abwurferkennung auf der Basis der Detektion eines Druckabfalls im Ist-Druckverlauf zugrunde liegt.

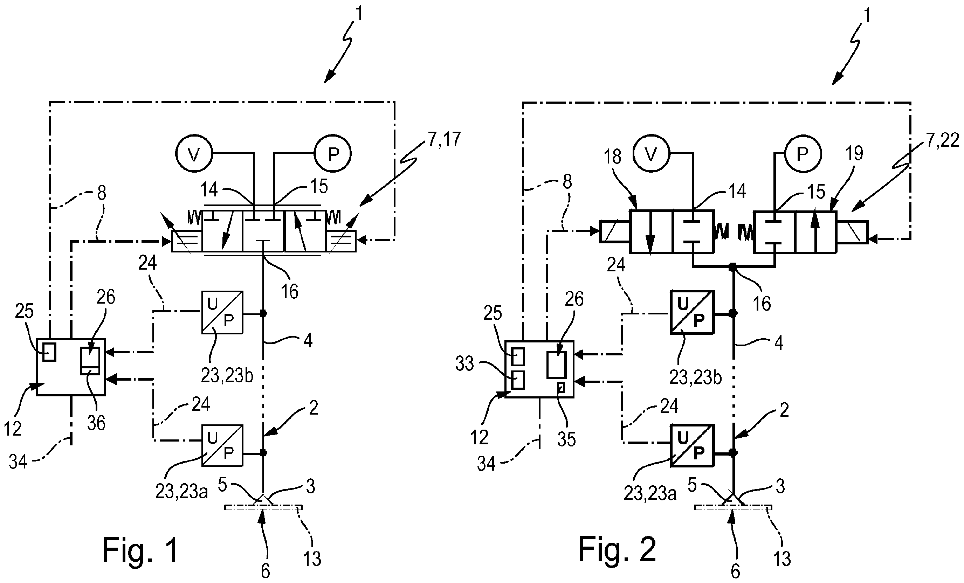

Die beiden in den Figuren 1 und 2 illustrierten Vakuum-Greifvorrichtungen 1 verfügen übereinstimmend über eine Sauggreifereinheit 2, die mindestens einen Sauggreifer 3 und eine an dem Sauggreifer 3 angeschlossene, zur Hindurchleitung von Luft geeignete Arbeitsleitung 4 enthalten.

Der Sauggreifer 3, beispielsweise ein Saugnapf oder ein Saugteller, begrenzt einen Saugraum 5, der an einer Arbeitsseite 6 des Sauggreifers 3 normalerweise offen ist und mit einem die Arbeitsleitung 4 durchziehenden Kanal in Fluidverbindung steht.

Die Arbeitsleitung 4 kann beispielsweise eine starre Rohrleitung oder ein in einem starren Körper beliebiger Art ausgebildeter Luftführungskanal sein. Besonders vorteilhaft ist eine Ausgestaltung als flexible Schlauchleitung, da sie eine besonders variable Verlegung gestattet. Eine typische Länge der Arbeitsleitung liegt zwischen 0,03 und 1,5 m. Abhängig vom Anwendungsfall kann die Arbeitsleitung 4 auch ganz entfallen.

An die Sauggreifereinheit 2 ist eine Steuerventileinrichtung 7 der Vakuum-Greifvorrichtung 1 angeschlossen. Auf diese Weise steht der Sauggreifer 3 und genauer gesagt dessen Saugraum 5 mit dieser Steuerventileinrichtung 7 in Fluidverbindung. Enthält die Sauggreifereinheit 2 wie beim Ausführungsbeispiel eine Arbeitsleitung 4, ist die Steuerventileinrichtung 7 zweckmäßigerweise an den dem Sauggreifer 3 entgegengesetzten Endabschnitt der Arbeitsleitung 4 angeschlossen.

Bei einem nicht gezeigten Ausführungsbeispiel ist unter Entfall der zusätzlichen Arbeitsleitung 4 der Sauggreifer 3 direkt an die Steuerventileinrichtung 7 angebaut.

Die Steuerventileinrichtung 7 ist zur Vorgabe ihres Betriebszustandes elektrisch ansteuerbar. Die dafür erforderlichen Steuersignale empfängt die Steuerventileinrichtung 7 über eine oder mehrere strichpunktiert angedeutete Steuerleitungen 8 von einer bevorzugt ebenfalls zu der Vakuum-Greifvorrichtung 1 gehörenden elektronischen Steuereinheit 12. Anstelle der Steuerleitungen 8 können auch Mittel zur drahtlosen Signalübertragung zwischen der elektronischen Steuereinheit 12 und der Steuerventileinrichtung 7 vorhanden sein.

Die elektronische Steuereinheit 12 kann autark arbeitend ausgebildet sein. Vorzugsweise ist sie allerdings mit Kommunikationsmitteln ausgestattet, die eine Kommunikation mit einer übergeordneten elektronischen Steuereinrichtung ermöglichen, die außer der Vakuum-Greifvorrichtung 1 noch weitere Vakuum-Greifvorrichtungen 1 und/oder auch sonstige Komponenten einer Anlage oder Maschine betriebsmäßig steuert.

Die Sauggreifereinheit 2 ist ausgangsseitig an die Steuerventileinrichtung 7 angeschlossen. Eingangsseitig kommuniziert die Steuerventileinrichtung 7 unabhängig voneinander mit einer Überdruckquelle P und einer Unterdruckquelle beziehungsweise Vakuumquelle V. Die Überdruckquelle P kann beliebig entfernt von der Steuerventileinrichtung 7 angeordnet sein und stellt unter Überdruck stehende Druckluft zur Verfügung, deren Höhe als Nennüberdruck bezeichnet sei. Bevorzugt enthält die Überdruckquelle P einen Druckluftspeicher und mindestens einen zur Generierung der Druckluft geeigneten Kompressor.

Die Vakuumquelle V stellt einen Unterdruck, also einen unterhalb des atmosphärischen Drucks liegenden Druck bereit. Die Vakuumquelle V ist beispielsweise eine Vakuumpumpe oder eine Ejektoreinrichtung, die über mindestens eine nach dem Ejektorprinzip arbeitende Saugdüse verfügt. Bei einer solchen Ejektoreinrichtung ist üblicherweise ein Einlass der Saugdüse an eine Druckluftquelle angeschlossen, während ein Auslass der Saugdüse zur Atmosphäre führt. Die Saugdüse hat außerdem eine Saugseite, an der ein Unterdruck erzeugt wird, wenn die Saugdüse von der Druckluft durchströmt wird und die zur Bereitstellung des Unterdruckes eingangsseitig an die Steuerventileinrichtung 7 angeschlossen ist.

Die Vakuum-Greifvorrichtung 1 ermöglicht es, Gegenstände 13, von denen einer in der Zeichnung beispielhaft als plattenförmiger Gegenstand illustriert ist, mittels Unterdruck zu greifen und beliebig lange festzuhalten. Bevorzugt ist der Sauggreifer 3 beweglich, sodass durch seine Bewegung ein Umpositionieren des ergriffenen Gegenstandes 13 durchführbar ist. An einem Ablageort, der in der Regel mit dem Aufnahmeort des Gegenstandes 13 nicht übereinstimmt, kann der ergriffene Gegenstand 13 wieder abgelegt werden. Man spricht in diesem Zusammenhang auch von einer Pick-and-Place-Anwendung. Um die vorgenannte Bewegung des Sauggreifers 3 zu ermöglichen, ist die Vakuum-Greifvorrichtung 1 üblicherweise mit geeigneten Positioniermitteln ausgestattet, beispielsweise mit einem mehrachsigen Positioniersystem. Die Positioniermittel können auch so ausgebildet sein, dass nicht nur der Sauggreife 3, sondern die gesamte Sauggreifereinheit 2 und unter Umständen sogar die Steuerventileinrichtung 7 die Positionierbewegung mitmacht.

Die Steuerventileinrichtung 7 ist derart ansteuerbar, dass sie wahlweise einen Überdruck-Betriebszustand oder einen Unterdruck-Betriebszustand einnimmt. Im Überdruck-Betriebszustand verbindet sie die Sauggreifereinheit 2 und mithin den Saugraum 5 des Sauggreifers 3 mit der Überdruckquelle P, im Unterdruck-Betriebszustand mit der Vakuumquelle V. Auf diese Weise ist an den Sauggreifer 3 beziehungsweise dessen Saugraum 5 wahlweise ein Überdruck oder ein Unterdruck anlegbar.

Um einen Gegenstand 13 zu ergreifen, wird der Sauggreifer 3 mit der zunächst noch offenen Arbeitsseite 6 voraus an den Gegenstand 13 angesetzt. Dabei wird die offene Arbeitsseite 6 des Saugraumes 5 von dem Gegenstand 13 verschlossen. Nach dem derartigen Ansetzen des Sauggreifers 3 an den Gegenstand 13, oder auch schon kurz vorher, wird die Steuerventileinrichtung 7 in den Unterdruck-Betriebszustand versetzt, sodass das Innere der Sauggreifereinheit 2, also der Saugraum 5 und der damit kommunizierende interne Kanal der optionalen Arbeitsleitung 4, evakuiert werden. Die dadurch an dem Gegenstand 13 anliegende Druckdifferenz sorgt dafür, dass der Gegenstand 13 an den Sauggreifer 3 angesaugt und daran festgehalten wird.

Um den ergriffenen Gegenstand 13 am gewünschten Ablageort abzulegen, wird die Steuerventileinrichtung 7 kurzzeitig in den Überdruck-Betriebszustand versetzt. Hieraus resultiert im Innern der Sauggreifereinheit 2 und folglich auch in dem Saugraum 5 ein Überdruckimpuls, der als Abwurfimpuls bezeichnet wird, weil er das aktive Abwerfen des Gegenstandes 13 vom Sauggreifer 3 bewirkt. Auf diese Weise ist ein klar definiertes und vor allem auch schnelles Ablegen des Gegenstandes 13 am Ablageort möglich.

Die Steuerventileinrichtung 7 kann vorzugsweise auch einen Absperr-Betriebszustand einnehmen, in dem die Sauggreifereinheit 2 sowohl von der Überdruckquelle P als auch von der Vakuumquelle V abgetrennt ist. Um einen Energiespareffekt zu erhalten, ist die Steuerventileinrichtung 7 vorzugsweise so ausgebildet, dass sie während des Festhaltens eines Gegenstandes 13 zwischen dem Unterdruck-Betriebszustand und dem Absperr-Betriebszustand umschaltbar ist, sodass die Sauggreifereinheit 2 nicht dauernd von der Vakuumquelle V beaufschlagt ist.

Die Steuerventileinrichtung 7 hat zweckmäßigerweise insgesamt eine 3/3-Wege-Funktionalität. Mit anderen Worten hat sie drei Anschlüsse - zwei Eingangsanschlüsse 14, 15, von denen der eine an die Überdruckquelle P und der andere an die Vakuumquelle V angeschlossen ist, und einen an die Sauggreifereinheit 2 angeschlossenen Ausgangsanschluss 16 - und kann in die drei oben erwähnten Betriebszustände versetzt werden.

Die Steuerventileinrichtung 7 kann sich aus einem einzigen Ventil oder auch aus einer funktionell verschalteten Ventilgruppe zusammensetzen. Das Ausführungsbeispiel der Figur 1 zeigt eine von einem Einzelventil gebildete Steuerventileinrichtung 7, bei der es sich vorzugsweise um eine Proportionalventileinrichtung 17 handelt. Bei dem Ausführungsbeispiel der Figur 2 setzt sich die Steuerventileinrichtung 7 aus zwei einzelnen Steuerventilen 18, 19 zusammen, von denen das eine die Verbindung zur Überdruckquelle P und das andere die Verbindung zur Vakuumquelle V steuert. Bei diesen beiden Steuerventilen 18, 19 handelt es sich zweckmäßigerweise um jeweils ein 2/2-Wegeventil. Diese beiden Steuerventile 18, 19 sind vorzugsweise als digital schaltbare Schaltventile ausgeführt. Somit repräsentiert die Steuerventileinrichtung 7 des Ausführungsbeispiels der Figur 2 eine digital schaltbare Schaltventileinrichtung 22.

Eine Ausgestaltung der Steuerventileinrichtung 7 als Proportionalventileinrichtung 17 ermöglicht es, die Strömungsrate der Luft sowohl während des Überdruck-Betriebszustandes als auch während des Unterdruck-Betriebszustandes variabel und insbesondere stufenlos vorzugeben. Bei einer Schaltventileinrichtung 22 hingegen ist sowohl im Überdruck-Betriebszustand als auch im Unterdruck-Betriebszustand jeweils der maximale Strömungsquerschnitt freigegeben.

Die Steuerventileinrichtung 7 ist vorzugsweise als eine Piezoventileinrichtung ausgeführt. Dies gilt insbesondere für die Proportionalventileinrichtung 17, trifft aber vorzugsweise auch für die Schaltventileinrichtung 22 zu. Piezoventile zeichnen sich durch besonders kurze Schaltzeiten aus, die die Überschwingneigung beim Abschalten des Überdruckes verringern. Durch das proportionale Ventilverhalten eröffnet sich insbesondere die vorteilhafte Möglichkeit einer Druckregelung.

Die Vakuum-Greifvorrichtung 1 ist des Weiteren mit mindestens einer Druckmesseinrichtung 23 ausgestattet, die in der Lage ist, den in der Sauggreifereinheit 2 aktuell herrschenden Druck, im Folgenden als Ist-Druck bezeichnet, zu messen. Die Druckmessung erfolgt vorzugsweise im Bereich des Sauggreifers 3 und/oder im Bereich der Steuerventileinrichtung 7. Die Ausführungsbeispiele sind gemäß einer vorteilhaften Ausstattungsvariante mit jeweils zwei Druckmesseinrichtungen 23 ausgestattet, wobei eine erste (23a) der Druckmesseinrichtungen 23 wirkungsmäßig im Übergangsbereich zwischen der Arbeitsleitung 4 und dem Sauggreifer 3 installiert ist, und eine zweite (23b) der Druckmesseinrichtungen 23 wirkungsmäßig im Übergangsbereich zwischen der Steuerventileinrichtung 7 und der Arbeitsleitung 4 installiert ist. Auf diese Weise besteht die Möglichkeit, den im Innern der Sauggreifereinheit 2 herrschenden Ist-Druck sowohl im Bereich des Sauggreifers 3 und folglich in unmittelbarer Nähe des Saugraumes 5 als auch im Bereich des Ausgangsanschlusses 16 der Steuerventileinrichtung 7 zu erfassen.

Beim Betrieb der Vakuum-Greifvorrichtung 1 können beide Druckmesseinrichtungen 23 zur Erfassung des in der Sauggreifereinheit 2 herrschenden Ist-Druckes parallel genutzt werden. Dabei ist die Druckmessung bezogen auf die sich auf den Saugraum 5 unmittelbar auswirkenden Ereignisse bei der weiter entfernt vom Saugraum 5 angeordneten zweiten Druckmesseinrichtung 23b etwas träger als bei der ersten Druckmesseinrichtung 23a.

Beide Druckmesseinrichtungen 23 sind über Signalleitungen 24 oder drahtlos an die elektronische Steuereinheit 12 angeschlossen und liefern dieser ein vom gemessenen Ist-Druck abhängiges Spannungssignal zur weiteren Auswertung und/oder Verarbeitung.

Die Steuereinheit 12 kann über Mittel verfügen, um die von den beiden Druckmesseinrichtungen 23a, 23b gemessenen Druckwerte in einer miteinander verknüpften Weise zu verarbeiten, beispielsweise durch eine Mittelwertbildung oder auch durch eine Kombination mit aufeinander abgestimmter Gewichtung. Bevorzugt bietet die Steuereinheit 12 aber auch die Möglichkeit, beim Betrieb der Vakuum-Greifvorrichtung 1 nur die Messwerte von einer der beiden Druckmesseinrichtungen 23a, 23b zu verarbeiten, wobei der Steuereinheit 12 zweckmäßigerweise Auswahlmittel 25 zugeordnet sind, die eine individuelle Auswahl und Vorgabe der für den momentanen Betrieb zu nutzenden Druckmesseinrichtung 23a, 23b ermöglichen.

Gemäß nicht illustrierten Ausführungsbeispielen kann die Vakuum-Greifvorrichtung 1 auch über nur eine einzige Druckmesseinrichtung 23 zur Erfassung des Ist-Druckes verfügen, die dann zweckmäßigerweise entweder im Bereich des Sauggreifers 3 oder im Bereich der Steuerventileinrichtung 7 wirkungsmäßig mit dem von der Luft beaufschlagten Innenraum der Sauggreifereinheit 2 verbunden ist.

Die elektronische Steuereinheit 12 ist bevorzugt mit elektronischen Steuermitteln 26 ausgestattet, die dazu ausgebildet sind, die Steuerventileinrichtung 7 zur Erzeugung des Abwurfimpulses abhängig von dem Ist-Druck anzusteuern, der sich nach der Verbindung mit der Überdruckquelle P in der Sauggreifereinheit 2 einstellt. Auf diese Weise besteht die vorteilhafte Möglichkeit, den Abwurfimpuls abhängig von dem sich nach der Verbindung mit der Überdruckquelle P in der Sauggreifereinheit 2 einstellenden Ist-Druck zu erzeugen. Somit ist eine den Randbedingungen des Einsatzes der Vakuum-Greifvorrichtung 1 Rechnung tragende adaptive Erzeugung des Abwurfimpulses möglich.

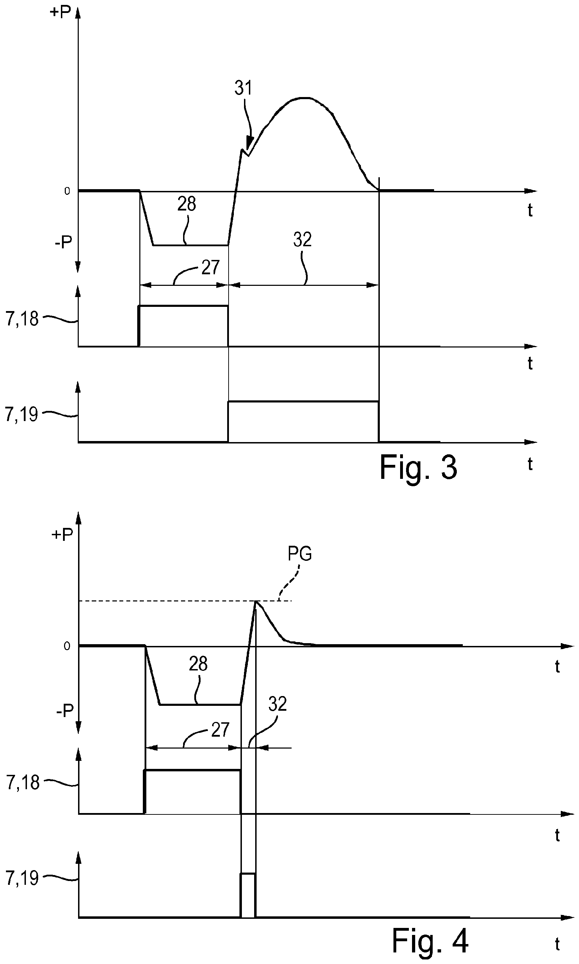

Die adaptive, sich an dem in der Sauggreifereinheit 2 herrschenden Ist-Druck orientierende Erzeugung des Abwurfimpulses lässt sich konkret mit verschiedenen technischen Methoden realisieren. Dazu werden im Folgenden anhand der in Figuren 4 bis 6 enthaltenen Diagramme drei als besonders vorteilhaft angesehene Betriebsverfahren erläutert.

Um die besonderen Vorteile der Erfindung deutlich zu machen, ist in dem Diagramm der Figur 3 der grundlegende Druckverlauf des Ist-Druckes beim Aufnehmen und Abwerfen eines Gegenstandes illustriert. Hier wie auch im Folgenden wird unter dem "Ist-Druck" der momentan im Innern der Sauggreifereinheit 2 herrschende und durch mindestens eine der Druckmesseinrichtungen 23 erfasste Innendruck verstanden.

Alle vier Diagramme der Figuren 3 bis 6 zeigen im oberen Teil den Verlauf des Ist-Druckes über der Zeit "t". Positive Drücke beziehungsweise Überdrücke sind mit +P bezeichnet, negative Drücke beziehungsweise Unterdrücke mit -P.

Unterhalb der Druck-Zeit-Kennlinie finden sich bei allen Diagrammen Kennlinien bezüglich des Betriebszustandes der Steuerventileinrichtung 7. Den anhand der Figuren 3, 4 und 6 illustrierten Verfahren liegt eine Vakuum-Greifvorrichtung 1 zugrunde, deren Steuerventileinrichtung 7 zwei digital schaltbare Steuerventile 18, 19 mit 2/2-Ventil-Funktionalität enthält, wobei das eine die Vakuumzufuhr und das andere die Überdruckzufuhr steuert, sodass sie im Folgenden auch als Vakuum-Steuerventil 18 und als Überdruck-Steuerventil 19 bezeichnet werden. In den Diagrammen ist jeweils der Schaltzustand abhängig von der Betriebszeit "t" aufgetragen. Das obere Betriebsdiagramm illustriert jeweils den Betriebszustand des Vakuum-Steuerventils 18, darunter ist der zeitabhängige Betriebszustand des Überdruck-Steuerventils 19 abgebildet. Die Betriebsabläufe der Diagramme gemäß Figuren 3, 4 und 6 lassen sich typischerweise bei der Vakuum-Greifvorrichtung 1 der Figur 2 realisieren.

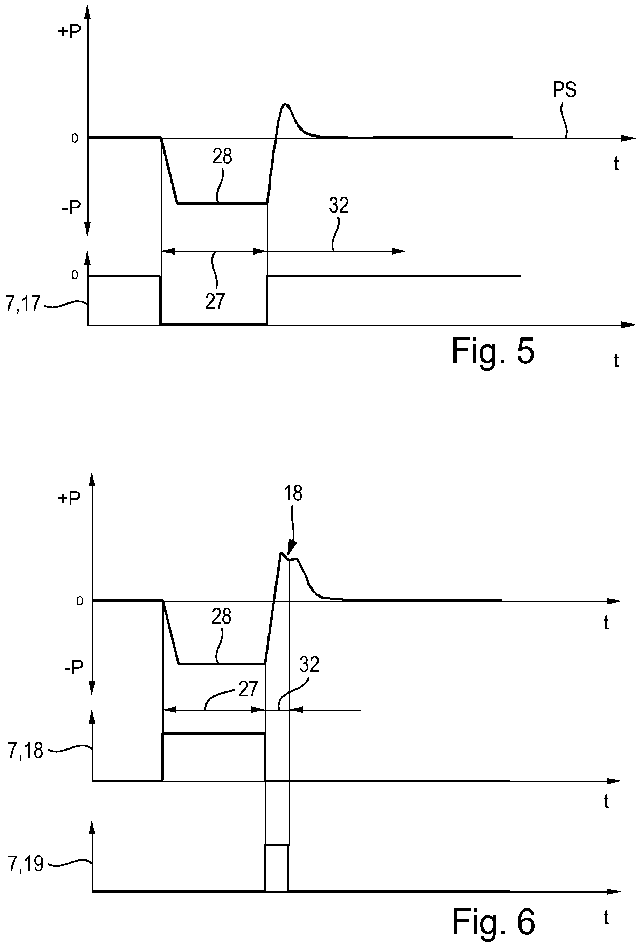

Die Figur 5 illustriert einen Betriebsablauf einer Vakuum-Greifvorrichtung 1, deren Steuerventileinrichtung 7 nach dem Vorbild der Figur 1 eine Proportionalventileinrichtung 17 ist. Das zugehörige Ventil-Betriebsdiagramm ist auch hier unterhalb der Druck-Zeit-Kennlinie illustriert.

Gemäß Figur 3 beginnt ein Betriebszyklus in der Schließstellung beider Steuerventile 18, 19, sodass der Ist-Druck gleich Null ist und folglich dem Atmosphärendruck entspricht.

Nachdem der Sauggreifer 3 an den zu ergreifenden Gegenstand 13 angesetzt wurde, schließt sich eine Ansaugphase 27 an, die daraus resultiert, dass das Vakuum-Steuerventil 18 geöffnet und das Überdruck-Steuerventil 19 geschlossen ist. Hierdurch sinkt der Ist-Druck unter den Atmosphärendruck ab und es bildet sich in der Sauggreifereinheit 2 einschließlich in dem Sauggreifer 3 ein Vakuum aus, durch das der Gegenstand 13 ergriffen und am Sauggreifer 3 festgehalten wird.

Während der Ansaugphase 27 und dabei insbesondere während der Einhaltung eines das maximale Vakuum definierenden Ist-Druckes kann der Sauggreifer 3 zwecks Umpositionierung des festgehaltenen Gegenstandes 13 verlagert werden. Der Kennlinienabschnitt 28 illustriert den maximalen Unterdruck 28 des Ist-Druckes.

An die Ansaugphase 27 schließt sich eine Abwurfphase 32 an, während der der angesaugte Gegenstand 13 durch Erzeugung des erwähnten Abwurfimpulses vom Sauggreifer 3 abgeworfen wird. Diese Abwurfphase 32 ist dadurch gekennzeichnet, dass das Vakuum-Steuerventil 18 in die Schließstellung und das Überdruck-Steuerventil 19 in die Offenstellung geschaltet ist. Die Zeitdauer der Abwurfphase 32 entspricht der Zeitdauer der die Überdruckquelle P mit der Sauggreifereinheit 2 verbindenden Offenstellung des Überdruck-Steuerventils 19.

Während der Abwurfphase 32 steigt der Ist-Druck zunächst an und überschreitet die Schwelle des Atmosphärendruckes. In dem Moment, in dem sich der Gegenstand 13 vom Sauggreifer 3 ablöst, verzeichnet der Druckverlauf des Ist-Druckes einen kurzzeitigen Druckabfall 31. Es folgt ein weiterer Druckanstieg, der dadurch bedingt ist, dass der bereits abgestoßene Gegenstand die Öffnung des Sauggreifers 3 weiterhin überdeckt und dadurch einen Strömungswiderstand bewirkt. Ist der Gegenstand 13 vom Sauggreifer 3 weit genug abgestoßen, sinkt der Ist-Druck allmählich auf den Atmosphärendruck ab. Nun kann auch das Überdruck-Steuerventil 19 wieder geschlossen werden.

Bei den in den Figuren 4 und 6 illustrierten Betriebsverfahren schließt sich entsprechend dem grundlegenden Ablauf der Figur 3 an die Stillstandsphase, in der sowohl das Vakuum-Steuerventil 18 als auch das Überdruck-Steuerventil 19 geschlossen sind, die Ansaugphase 27 mit geöffnetem Vakuum-Steuerventil 18 und geschlossenem Überdruck-Steuerventil 19 an. Im Unterschied zu dem konventionellen Betriebsablauf der Figur 3 fällt allerdings die sich anschließende Abwurfphase 32, die wiederum durch das Schließen des Vakuum-Steuerventils 18 und das Öffnen des Überdruck-Steuerventils 19 hervorgerufen wird, wesentlich kürzer aus.

Der Grund hierfür ist bei dem in Figur 4 illustrierten Betriebsverfahren, dass während der Abwurfphase 32 mittels mindestens einer Druckmesseinrichtung 23 der in der Sauggreifereinheit 2 herrschende Ist-Druck gemessen wird und die Überdruckquelle P durch entsprechende Ansteuerung der Schaltventileinrichtung 22 von der Sauggreifereinheit 2 abgetrennt wird, wenn der gemessene Ist-Druck einen vorgegebenen Überdruck-Grenzwert PG erreicht hat.

Die elektronische Steuereinheit 12 ist zweckmäßigerweise mit Speichermitteln 33 ausgestattet, in denen der Überdruck-Grenzwert PG abspeicherbar und/oder abgespeichert ist. Der Steuereinheit 12 zugeordnete, nur schematisch angedeutete Eingabemittel 34 ermöglichen zweckmäßigerweise eine bedarfsgemäße Eingabe des für den Betriebsablauf gewünschten Überdruck-Grenzwertes PG, der sich insbesondere an den Abmessungen und/oder am Gewicht der zu greifenden Gegenstände 13 orientiert. Zu den Steuermitteln 26 gehörende Vergleichermittel führen einen ständigen Vergleich des gemessenen Ist-Druckes mit dem abgespeicherten Überdruck-Grenzwert PG durch und veranlassen das Schließen des Überdruck-Steuerventils 19, sobald der Ist-Druck den vorgegebenen Überdruck-Grenzwert PG erreicht hat. Das Vakuum-Steuerventil 18 bleibt dabei weiterhin geschlossen. Auf diese Weise ist der Abwurfimpuls schlagartig beendet. Das schnelle Abtrennen der Überdruckquelle P von der Sauggreifereinheit 2 wird durch die Verwendung einer Piezoventileinrichtung 17 begünstigt.

Dadurch, dass die Abwurfphase 32 beziehungsweise die Erzeugung des Abwurfimpulses erst unterbrochen wird, nachdem der Ist-Druck einen Überdruckwert erreicht hat, ist ein sicheres Abwerfen des gegriffenen Gegenstandes 13 garantiert. Als Überdruck-Grenzwert PG, der auch als Schwellwert bezeichnet werden kann, wird zweckmäßigerweise ein relativ geringer Überdruck eingestellt beziehungsweise vorgegeben, sodass ein unkontrolliertes Wegblasen des gelösten Gegenstandes 13 vom Sauggreifer 3 oder sonstige Beeinträchtigungen in der näheren Umgebung des Sauggreifers 3 verhindert werden. Als optimal hat es sich erwiesen, den Überdruck-Grenzwert in einem Bereich zwischen 0,05 bar und 0,15 bar zu wählen, und dabei insbesondere in einem Bereich von ca. 0,1 bar.

Während also das Betriebsverfahren gemäß Figur 4 darauf basiert, dass der Abwurfimpuls durch eine Druckschwelle beziehungsweise einen Druckgrenzwert vorgegeben ist, basiert das in Figur 6 illustrierte Verfahren auf der Erkennung des weiter oben anhand der Erläuterung des Diagramms der Figur 3 erwähnten Druckabfalls 31.

Wiederum wird auch bei dem Verfahren der Figur 6 der in der Sauggreifereinheit 2 während der Erzeugung des Abwurfimpulses auftretende Ist-Druck gemessen. Beendet wird die Abwurfphase 32 jedoch nicht durch einen starr vorgegebenen DruckGrenzwert, sondern durch das Auftreten des während der Erzeugung des Abwurfimpulses erstmals auftretenden Druckabfalls 31 im Verlauf des Ist-Druckes. Sobald dieser Druckabfall 31 durch mindestens eine Druckmesseinrichtung 23 gemessen wurde, veranlasst die elektronische Steuereinheit 12 das Abtrennen der Überdruckquelle P von der Sauggreifereinheit 2, was im konkreten Fall ein Schließen des Überdruck-Steuerventils 19 bedeutet, sodass die Sauggreifereinheit 2 sowohl von der Überdruckquelle P als auch von der Vakuumquelle V abgetrennt ist.

Zur einfachen Erkennung des Druckabfalls 31 sind die Steuermittel 26 zweckmäßigerweise mit Differenziermitteln ausgestattet, die das erfasste Drucksignal des Ist-Druckes elektronisch differenzieren und den Druckabfall durch Ermittlung einer negativen Steigung des Ist-Druckverlaufes detektieren.

Vorzugsweise ist die elektronische Steuereinheit 12 mit mindestens einem Signalausgabemittel 35 ausgestattet, an dem ein Abwurfbestätigungssignal ausgebbar ist oder ausgegeben wird, sobald der Druckabfall 31 detektiert wurde. Dieses Abwurfbestätigungssignal gibt zweifelsfrei zu erkennen, dass der ergriffene Gegenstand abgeworfen worden ist. Das Abwurfbestätigungssignal kann ein optisches Signal und/oder ein elektronisches Signal sein. Letzteres lässt sich in vorteilhafter Weise bei der Steuerung des fortgesetzten Betriebsablaufes der Vakuum-Greifvorrichtung 1 verwenden.

Bei dem dem Diagramm der Figur 5 zugrundeliegenden Betriebsverfahren wird eine Greifvorrichtung 1 eingesetzt, die - beispielsweise nach dem Vorbild der Figur 1 - eine als Proportionalventileinrichtung 17 ausgebildete Steuerventileinrichtung 7 aufweist. Grundlage der Erzeugung des Abwurfimpulses ist hier eine Regelung des Ist-Druckes während der Abwurfphase 32, die sich auch hier an eine vorgeschaltete Ansaugphase 27 anschließt.

In Figur 5 ist unterhalb der Druck-Zeit-Kennlinie der Sollwert der als Regelventil eingesetzten Steuerventileinrichtung 7 in Abhängigkeit von der Zeit "t" aufgetragen. Während der Ansaugphase 27 ist der Strömungsquerschnitt zwischen der Sauggreifereinheit 2 und der Vakuumquelle V vollständig geöffnet, um einen schnellstmöglichen Druckabfall und folglich ein schnellstmögliches Ergreifen eines Gegenstandes 13 zu gewährleisten. Während der sich daran anschließenden Abwurfphase 32 wird wiederum der im Innern der Sauggreifereinheit 2 herrschende Ist-Druck mittels mindestens einer Druckmesseinrichtung 23 ständig gemessen und durch entsprechende geregelte Ansteuerung der Steuerventileinrichtung 7 auf einen vorgegebenen Soll-Druck geregelt. Der Steuereinheit 12 zugeordnete Eingabemittel 34 ermöglichen vorzugsweise eine variable Eingabe des gewünschten Druckwertes des Soll-Druckes durch den Bediener der Vakuum-Greifvorrichtung oder durch eine externe elektronische Steuereinrichtung.

Bevorzugt wird als Soll-Druck der Atmosphärendruck vorgegeben. Dadurch wird der Ist-Druck während der Abwurfphase 32 auf einen Soll-Druck von Null bar ausgeregelt. Die über entsprechende Regelungsmittel 36 verfügenden Steuermittel 26 sind dabei so parametriert, dass im Druckverlauf des Ist-Druckes ein gezieltes und kontrolliertes Überschwingen in den Überdruckbereich provoziert wird. Dadurch ist sichergestellt, dass das Vakuum in der Sauggreifereinheit 2 vollständig abgebaut wurde und sich der bis dahin gegriffene Gegenstand vom Sauggreifer 3 gelöst hat. Prinzipiell könnte der Ist-Druck während der Abwurfphase 32 auch auf einen Soll-Druck eingeregelt werden, der etwas größer ist als der Atmosphärendruck. Die Regelung auf den Atmosphärendruck ist jedoch insbesondere auch aus Gesichtspunkten der Energieeffizienz wesentlich vorteilhafter.

Es versteht sich, dass beim Betrieb der Vakuum-Greifvorrichtung mittels der mindestens einen Druckmesseinrichtung 23 eine Druckerfassung des Ist-Druckes nicht nur während der Erzeugung des Abwurfimpulses erfolgen kann, sondern bevorzugt auch während der anderen Betriebsphasen stattfindet, insbesondere während der Ansaugphase 27. Auf diese Weise ist stets sichergestellt, dass das in der Sauggreifereinheit 2 anliegende Vakuum ausreichend groß ist, um einen Gegenstand 13 sicher festhalten zu können.

Die mindestens eine Druckmesseinrichtung 23 kann bei Bedarf auch genutzt werden, um während der Ansaugphase 27 eine Druckregelung vorzunehmen und den Ist-Druck trotz vorübergehender Unterbrechung der Unterdruckversorgung auf einem ausreichend hohen Niveau zu halten. Dies gestattet es, den Unterdruckbetrieb zur Energieeinsparung zeitweilig abzuschalten.

## Patentansprüche

1. Verfahren zum Betreiben einer Vakuum-Greifvorrichtung, die eine mindestens einen Sauggreifer (3) aufweisende Sauggreifereinheit (2) enthält, die über eine an sie angeschlossene Steuerventileinrichtung (7) wahlweise mit einer in dem Sauggreifer (3) einen Unterdruck hervorrufenden Vakuumquelle (V) oder mit einer in dem Sauggreifer (3) einen Abwurfimpuls erzeugenden Überdruckquelle (P) verbindbar ist, wobei der Abwurfimpuls abhängig von dem sich nach Verbindung mit der Überdruckquelle (P) in der Sauggreifereinheit (2) einstellenden Ist-Druck erzeugt wird, **dadurch gekennzeichnet, dass** während der Erzeugung des Abwurfimpulses ein in der Sauggreifereinheit (2) herrschender Ist-Druck gemessen wird und die Überdruckquelle (P) mittels der Steuerventileinrichtung (7) von der Sauggreifereinheit (2) abgetrennt wird, wenn bei der Messung des Ist-Druckes ein Druckabfall (31) detektiert wird.

2. Verfahren nach Anspruch 1, **dadurch gekennzeichnet, dass** während der Erzeugung des Abwurfimpulses ein in der Sauggreifereinheit (2) herrschender Ist-Druck gemessen wird und die Überdruckquelle (P) mittels der Steuerventileinrichtung (7) von der Sauggreifereinheit (2) abgetrennt wird, wenn der gemessene Ist-Druck einen vorgegebenen Überdruck-Grenzwert (PG) erreicht hat.

3. Verfahren nach Anspruch 2, **dadurch gekennzeichnet, dass** als Überdruck-Grenzwert (PG) ein Druck im Bereich zwischen 0,05 bar und 0,15 bar und vorzugsweise ein Druck im Bereich von 0,1 bar gewählt wird.

4. Verfahren nach Anspruch 1, **dadurch gekennzeichnet, dass** während der Erzeugung des Abwurfimpulses ein in der Sauggreifereinheit (2) herrschender Ist-Druck gemessen wird und dieser Ist-Druck unter zumindest kurzzeitiger Überschreitung des Atmosphärendruckes durch entsprechende Ansteuerung der Steuerventileinrichtung (7) auf einen Soll-Druck (PS) geregelt wird.

5. Verfahren nach Anspruch 4, **dadurch gekennzeichnet, dass** als Soll-Druck (PS) der atmosphärische Druck vorgegeben wird und die Druckregelung derart parametriert ausgeführt wird, dass im Druckverlauf des Ist-Druckes während des Regelungsvorganges ein Überschwingen auf einen Überdruck stattfindet.

6. Verfahren nach Anspruch 1, **dadurch gekennzeichnet, dass** die Detektion des Druckabfalls (31) durch Ermittlung einer negativen Steigung des Ist-Druckverlaufes im Rahmen einer Differenzierung des gemessenen Ist-Druckverlaufes erfolgt.

7. Verfahren nach Anspruch 1 oder 6, **dadurch gekennzeichnet, dass** basierend auf der Detektion des Druckabfalls (31) ein Abwurfbestätigungssignal erzeugt wird.

8. Verfahren nach einem der Ansprüche 1 bis 7, **dadurch gekennzeichnet, dass** die Sauggreifereinheit (2) eine mit dem mindestens einen Sauggreifer (3) verbundene und an die Steuerventileinrichtung (7) angeschlossene Arbeitsleitung (4) enthält, die insbesondere von einer flexiblen Schlauchleitung gebildet ist.

9. Verfahren nach Anspruch 8 in Verbindung mit einem der Ansprüche 2 bis 7, **dadurch gekennzeichnet, dass** der Ist-Druck im Bereich des Sauggreifers (3) gemessen wird, insbesondere im Übergangsbereich zwischen der Arbeitsleitung (4) und dem Sauggreifer (3).

10. Verfahren nach Anspruch 8 in Verbindung mit einem der Ansprüche 2 bis 7, **dadurch gekennzeichnet, dass** der Ist-Druck im Bereich der Steuerventileinrichtung (7) gemessen wird, insbesondere im Übergangsbereich zwischen der Steuerventileinrichtung (7) und der Arbeitsleitung (4).

11. Verfahren nach einem der Ansprüche 1 bis 10, **dadurch gekennzeichnet, dass** als Steuerventileinrichtung (7) eine Proportionalventileinrichtung (17) verwendet wird, insbesondere eine Piezoventileinrichtung.

12. Verfahren nach einem der Ansprüche 1 bis 11, **dadurch gekennzeichnet, dass** als Steuerventileinrichtung (7) eine digital schaltbare Schaltventileinrichtung (22) verwendet wird, die zweckmäßigerweise für die Steuerung der Verbindung mit der Überdruckquelle (P) und für die Steuerung der Verbindung mit der Vakuumquelle (V) jeweils ein eigenes Steuerventil (18, 19) enthält.

13. Vakuum-Greifvorrichtung, die eine mindestens einen Sauggreifer (3) aufweisende Sauggreifereinheit (2) enthält, die über eine an sie angeschlossene Steuerventileinrichtung (7) wahlweise mit einer in dem Sauggreifer (3) einen Unterdruck hervorrufenden Vakuumquelle (V) oder mit einer in dem Sauggreifer (3) einen Abwurfimpuls erzeugenden Überdruckquelle (P) verbindbar ist, wobei zur Ansteuerung der Steuerventileinrichtung (7) eine elektronische Steuereinheit (12) vorhanden ist und wobei der Sauggreifereinheit (2) mindestens eine zur Messung des in ihr herrschenden Ist-Druckes geeignete und mit der elektronischen Steuereinheit (12) kommunizierende Druckmesseinrichtung (23) zugeordnet ist, wobei die elektronische Steuereinheit (12) über Steuermittel (26) verfügt, durch die die Steuerventileinrichtung (7) zur Erzeugung des Abwurfimpulses abhängig von dem sich nach Verbindung mit der Überdruckquelle (P) in der Sauggreifereinheit (2) einstellenden Ist-Druck ansteuerbar ist, **dadurch gekennzeichnet, dass** die Vakuum-Greifvorrichtung zur Ausführung des Verfahrens nach einem der Ansprüche 1 bis 12 ausgebildet ist.

## Claims

1. Method for operating a vacuum gripping device comprising a suction gripper unit (2), which is provided with at least one suction gripper (3) and which can be connected, via a control valve device (7) connected to the suction gripper unit (2), selectively to a vacuum source (V) causing a negative pressure in the suction gripper (3) or to a positive pressure source (P) generating an ejector pulse in the suction gripper (3), wherein the ejector pulse is generated as a function of the actual pressure established in the suction gripper unit (2) after its connection to the positive pressure source (P), **characterised in that**, during the generation of the ejector pulse, an actual pressure prevailing in the suction gripper unit (2) is measured and the positive pressure source (P) is disconnected from the suction gripper unit (2) by means of the control valve device (7) when a pressure drop (31) is detected during the measurement of the actual pressure.

2. Method according to claim 1, **characterised in that** an actual pressure prevailing in the suction gripper unit (2) is measured during the generation of the ejector pulse and the positive pressure source (P) is disconnected from the suction gripper unit (2) by means of the control valve device (7) when the measured actual pressure has reached a preset positive pressure limit value (PG).

3. Method according to claim 2, **characterised in that** a pressure of 0.05 bar to 0.15 bar and in particular in the range of 0.1 bar is chosen as a positive pressure limit value (PG).

4. Method according to claim 1, **characterised in that**, during the generation of the ejector pulse, an actual pressure prevailing in the suction gripper unit (2) is measured, and this actual pressure is regulated to provide a target pressure (PS) by suitable control of the control valve device (7) accompanied by an at least short-time overshooting of atmospheric pressure.

5. Method according to claim 4, **characterised in that** atmospheric pressure is preset as target pressure (PS) and the pressure control is parameterised in such a way that an overshooting into a positive pressure occurs in the pressure course of the actual pressure during the control process.

6. Method according to claim 1, **characterised in that** the pressure drop (31) is detected by determining a negative gradient of the actual pressure course within a differentiation of the measured actual pressure course.

7. Method according to claim 1 or 6, **characterised in that** an ejection confirmation signal is generated on the basis of the detection of the pressure drop (31).

8. Method according to any of claims 1 to 7, **characterised in that** the suction gripper unit (2) comprises a working line (4) connected to the at least one suction gripper (3) and to the control valve device (7), which working line (4) is in particular formed by a flexible hose line.

9. Method according to claim 8 in combination with any of claims 2 to 7, **characterised in that** the actual pressure is measured in the region of the suction gripper (3), in particular in the transitional region between the working line (4) and the suction gripper (3).

10. Method according to claim 8 in combination with any of claims 2 to 7, **characterised in that** the actual pressure is measured in the region of the control valve device (7), in particular in the transitional region between the control valve device (7) and the working line (4).

11. Method according to any of claims 1 to 10, **characterised in that** a proportional valve device (17), in particular a piezoelectric valve device, is used as a control valve device (7).

12. Method according to any of claims 1 to 11, **characterised in that** a digitally switchable switching valve device (22), which expediently comprises individual control valves (18, 19) for the control of the connection to the positive pressure source (P) and for the control of the connection to the vacuum source (V), is used as a control valve device (7).

13. Vacuum gripping device comprising a suction gripper unit (2), which is provided with at least one suction gripper (3) and which can be connected, via a control valve device (7) connected to the suction gripper unit (2), selectively to a vacuum source (V) causing a negative pressure in the suction gripper (3) or to a positive pressure source (P) generating an ejector pulse in the suction gripper (3), wherein an electronic control unit (12) is provided for controlling the control valve device (7), and wherein at least one pressure measurement device (23) suitable for measuring the actual pressure prevailing in the suction gripper unit (2) and communicating with the electronic control unit (12) is assigned to the suction gripper unit (2), wherein the electronic control unit (12) is provided with control means (26), by means of which the control valve device (7) can be controlled for generating the ejector pulse as a function of the actual pressure established in the suction gripper unit (2) after its connection to the positive pressure source (P), **characterised in that** the vacuum gripping device is designed to execute the method according to any of claims 1 to 12.

## Revendications

1. Procédé servant à faire fonctionner un dispositif de préhension sous vide, qui contient une unité à grappin aspirant (2) présentant au moins un grappin aspirant (3), qui peut être reliée sélectivement par l'intermédiaire d'un dispositif de soupape de commande (7) raccordée à celle-ci à une source de vide (V) provoquant une dépression dans le grappin aspirant (3) ou à une source de surpression (P) générant une impulsion d'éjection dans le grappin aspirant (3), dans lequel l'impulsion d'éjection est générée en fonction de la pression réelle se réglant selon la liaison à la source de surpression (P) dans l'unité à grappin aspirant (2), **caractérisé en ce que** pendant la génération de l'impulsion d'éjection, une pression réelle régnant dans l'unité à grappin aspirant (2) est mesurée et la source de surpression (P) est séparée de l'unité à grappin aspirant (2) au moyen du dispositif de soupape de commande (7) quand lors de la mesure de la pression réelle, une baisse de pression (31) est détectée.

2. Procédé selon la revendication 1, **caractérisé en ce que** pendant la génération de l'impulsion d'éjection, une pression réelle régnant dans l'unité à grappin aspirant (2) est mesurée et la source de surpression (P) est séparée de l'unité à grappin aspirant (2) au moyen du dispositif de soupape de commande (7) quand la pression réelle mesurée a atteint une valeur limite de surpression (PG) prédéfinie.

3. Procédé selon la revendication 2, **caractérisé en ce qu'**est choisie en tant que valeur limite de surpression (PG) une pression dans la plage entre 0,05 bar et 0,15 bar et de préférence une pression dans la plage de 0,1 bar.

4. Procédé selon la revendication 1, **caractérisé en ce que** pendant la génération de l'impulsion d'éjection, une pression réelle régnant dans l'unité à grappin aspirant (2) est mesurée, et ladite pression réelle est régulée sur une pression théorique (PS) par un pilotage correspondant du dispositif de soupape de commande (7) en dépassant au moins brièvement la pression atmosphérique.

5. Procédé selon la revendication 4, **caractérisé en ce que** la pression atmosphérique est prédéfinie en tant que pression théorique (PS) et la régulation de pression est paramétrée de telle manière qu'une suroscillation sur une surpression a lieu lors de l'évolution de la pression réelle pendant l'opération de régulation.

6. Procédé selon la revendication 1, **caractérisé en ce que** la détection de la baisse de pression (31) est effectuée en déterminant une hausse négative de l'évolution de pression réelle dans le cadre d'une différenciation de l'évolution de pression réelle mesurée.

7. Procédé selon la revendication 1 ou 6, **caractérisé en ce qu'**un signal de confirmation d'éjection est généré sur la base de la détection de la baisse de pression (31).

8. Procédé selon l'une quelconque des revendications 1 à 7, **caractérisé en ce que** l'unité à grappin aspirant (2) contient un conduit de travail (4), relié à l'au moins un grappin aspirant (3) et raccordé au dispositif de soupape de commande (7), qui est formé en particulier par un conduit flexible.

9. Procédé selon la revendication 8 en lien avec l'une quelconque des revendications 2 à 7, **caractérisé en ce que** la pression réelle est mesurée dans la zone du grappin aspirant (3), en particulier dans la zone de transition entre le conduit de travail (4) et le grappin aspirant (3).

10. Procédé selon la revendication 8 en lien avec l'une quelconque des revendications 2 à 7, **caractérisé en ce que** la pression réelle est mesurée dans la zone du dispositif de soupape de commande (7), en particulier dans la zone de transition entre le dispositif de soupape de commande (7) et le conduit de travail (4).

11. Procédé selon l'une quelconque des revendications 1 à 10, **caractérisé en ce qu'**un dispositif de soupape proportionnelle (17), en particulier un dispositif de soupape piézoélectrique, est utilisé en tant que dispositif de soupape de commande (7).

12. Procédé selon l'une quelconque des revendications 1 à 11, **caractérisé en ce qu'**un dispositif de soupape de commutation (22) pouvant être commuté de manière numérique est utilisé en tant que dispositif de soupape de commande (7), qui contient de manière appropriée pour la commande de la liaison à la source de surpression (P) et pour la commande de la liaison à la source de vide (V) respectivement une soupape de commande (18, 19) propre.

13. Dispositif de préhension sous vide, qui contient une unité à grappin aspirant (2) présentant au moins un grappin aspirant (3), qui peut être reliée sélectivement par l'intermédiaire d'un dispositif de soupape de commande (7) raccordé à celle-ci à une source de vide (V) entraînant une dépression dans le grappin aspirant (3) ou à une source de surpression (P) générant une impulsion d'éjection dans le grappin aspirant (3), dans lequel une unité de commande (12) électronique est présente pour piloter le dispositif de soupape de commande (7) et dans lequel est associé à l'unité à grappin aspirant (2) au moins un dispositif de mesure de pression (23) adapté pour mesurer la pression réelle régnant dans celle-ci et communiquant avec l'unité de commande (12) électronique, dans lequel l'unité de commande (12) électronique dispose de moyens de commande (26), par lesquels le dispositif de soupape de commande (7) peut être piloté pour générer l'impulsion d'éjection en fonction de la pression réelle se réglant selon la liaison à la source de surpression (P) dans l'unité à grappin aspirant (2), **caractérisé en ce que** le dispositif de préhension sous vide est réalisé pour mettre en œuvre le procédé selon l'une quelconque des revendications 1 à 12.
